# EUROPEAN PATENT APPLICATION

(11) **EP 4 527 860 A1**
(43) Date of publication of application: **26.03.2025**
(21) Application number: 23807623.6
(22) Date of filing: 16.05.2023
(51) Int. Cl.: C08F 212/00, B32B 15/08, C08F 222/40, C08F 290/14, C08J 5/18, C08J 5/24, H01L 23/29, H01L 23/31, H05K 1/03

(54) **RESIN COMPOSITION, PREPREG, LAMINATE, RESIN FILM, PRINTED WIRING BOARD AND SEMICONDUCTOR PACKAGE**

(30) Priority: 19.05.2022 JP 2022082081
(71) Applicant: Resonac Corporation, Tokyo 105-7325 (JP)
(72) Inventor: YAMASHITA, Takeshi, Tokyo 1057325 (JP); KOTAKE, Tomohiko, Tokyo 1057325 (JP)
(74) Representative: Hoffmann Eitle
(86) International application number: PCT/JP2023/018197
(87) International publication number: WO 2023/224021

(57) **Abstract**

The present invention provides a resin composition containing (A) one or more selected from the group consisting of a maleimide resin having one or more N-substituted maleimide groups and a derivative of the maleimide resin, and (B) a compound having a vinyl benzyl group, in which the component (B) contains one or more selected from the group consisting of (B1) a compound having 3 or more vinyl benzyl groups bonded to an oxygen atom and (B2) a compound having one or more vinyl benzyl groups bonded to a carbon atom, and a prepreg, a laminate, a resin film, a printed wiring board, and a semiconductor package in which the resin composition is used.

## Description

### Technical Field

The present embodiment relates to a resin composition, a prepreg, a laminate, a resin film, a printed wiring board, and a semiconductor package.

### Background Art

In electronic devices such as a mobile communication device represented by a mobile phone, a base station device thereof, a network infrastructure device such as a server, or a router, or a large computer, the speed and the capacity of a signal to be used are increasing year by year. Accordingly, dielectric characteristics capable of reducing a transmission loss of a high-frequency signal (hereinafter, sometimes referred to as "high-frequency characteristics"), that is, a low relative permittivity and a low dielectric dissipation factor are required for a substrate material and a semiconductor sealing material to be mounted on these electronic devices.

The substrate material and the semiconductor sealing material are required to have heat resistance that can withstand the use environment. A maleimide resin, which is one thermosetting resin, has excellent heat resistance and mechanical properties, thus to be applied to a substrate material for a printed wiring board, or the like (for example, PTL 1).

### Citation List

### Patent Literature

PTL 1:JP-A-2009-1783

### Summary of Invention

### Technical Problem

However, the maleimide resin contains a large number of polar groups, and thus has a problem of poor dielectric characteristics, and improvement is required.

In view of such a current situation, an object of the present embodiment is to provide a resin composition having excellent dielectric characteristics, a prepreg, a laminate, a resin film, a printed wiring board, and a semiconductor package in which the resin composition is used.

### Solution to Problem

The present inventors have conducted studies to solve the above-described problems, and as a result, have found that the problem can be solved by the following embodiments [1] to [12].
[1] A resin composition containing (A) one or more selected from the group consisting of a maleimide resin having one or more N-substituted maleimide groups and a derivative of the maleimide resin, and
   (B) a compound having a vinyl benzyl group,
   in which the component (B) contains one or more selected from the group consisting of (B1) a compound having 3 or more vinyl benzyl groups bonded to an oxygen atom and (B2) a compound having one or more vinyl benzyl groups bonded to a carbon atom.
[2] The resin composition according to [1], in which the component (B) contains the component (B1), and
   the component (B1) is a compound having a structural unit represented by the following general formula (B-1): 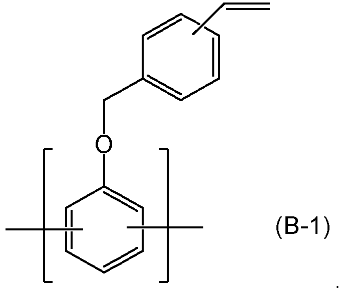
[3] The resin composition according to [1], in which the component (B) contains the component (B2), and
   the component (B2) is a compound having a condensed polycyclic structure containing an aromatic ring and a non-aromatic ring.
[4] The resin composition according to [3], in which the condensed polycyclic structure containing an aromatic ring and a non-aromatic ring is an indene ring.
[5] The resin composition according to any one of [1] to [4], in which the component (A) is an aromatic bismaleimide resin having two N-substituted maleimide groups.
[6] The resin composition according to any one of [1] to [5], in which a content ratio [N-substituted maleimide group/vinyl group] of the N-substituted maleimide group derived from the component (A) to a vinyl group derived from the component (B) is 0.05 to 5 on a molar basis.
[7] A prepreg containing the resin composition according to any one of [1] to [6] or a semi-cured product of the resin composition.
[8] A laminate including a cured product of the resin composition according to any one of [1] to [6], and a metal foil.
[9] A resin film containing the resin composition according to any one of [1] to [6] or a semi-cured product of the resin composition.
[10] A printed wiring board including a cured product of the resin composition according to any one of [1] to [6].
[11] A semiconductor package including the printed wiring board according to [10], and a semiconductor element.
[12] A semiconductor package including a semiconductor element and a cured product of the resin composition according to any one of [1] to [6] that seals the semiconductor element.

### Advantageous Effects of Invention

According to the present embodiment, it is possible to provide a resin composition having excellent dielectric characteristics, a prepreg, a laminate, a resin film, a printed wiring board, and a semiconductor package in which the resin composition is used.

### Description of Embodiments

In the present description, a numerical range indicated by using "to" indicates a range including numerical values described before and after "to" as a minimum value and a maximum value, respectively.

For example, the expression of a numerical range "X to Y" (X and Y are real numbers) means a numerical range that is X or more and Y or less. Further, the expression of "X or more" in the present description means X and a numerical value exceeding X. Furthermore, the expression of "Y or less" in the present description means Y and a numerical value less than Y.

The lower limit value and the upper limit value of a numerical range described in the present description can be arbitrarily combined with the lower limit value or the upper limit value of another numerical range, respectively.

In a numerical range described in the present description, the lower limit value or the upper limit value of the numerical range may be replaced with a value shown in Examples.

Each component and material exemplified in the present description may be used alone or may be used in combination of two or more kinds thereof, unless particularly otherwise specified.

In the present description, when a plurality of substances corresponding to each component are present in a resin composition, the content of each component in the resin composition means the total amount of the plurality of substances present in the resin composition, unless particularly otherwise specified.

In the present description, the "solid content" means a nonvolatile content excluding a volatile substance such as a solvent. That is, the "solid content" refers to a component that remains without being volatilized when the resin composition is dried, and also includes liquid, syrup, and wax-like components at room temperature. In the present description, the room temperature means 25°C.

The weight-average molecular weight (Mw) and the number-average molecular weight (Mn) in the present description mean values measured in terms of polystyrene by gel permeation chromatography (GPC). Specifically, the weight-average molecular weight (Mw) and the number-average molecular weight (Mn) in the present description can be measured by the method described in Examples.

The "semi-cured product" in the present description is synonymous with the resin composition in the B-stage state in JIS K6800 (1985), and the "cured product" is synonymous with the resin composition in the C-stage state in JIS-K6800 (1985).

The mechanism of action described in the present description is a conjecture, and does not limit the mechanism of achieving the effect of the present embodiment.

Aspects in which the matters described in the present description are arbitrarily combined are also included in the present embodiment.

### [Resin Composition]

A resin composition of the present embodiment is a resin composition containing
(A) one or more selected from the group consisting of a maleimide resin having one or more N-substituted maleimide groups and a derivative of the maleimide resin, and
(B) a compound having a vinyl benzyl group,
in which the component (B) contains one or more selected from the group consisting of (B1) a compound having 3 or more vinyl benzyl groups bonded to an oxygen atom and (B2) a compound having one or more vinyl benzyl groups bonded to a carbon atom.

In the present description, each component may be sometimes referred to as an abbreviation such as the component (A), the component (B), which will be true for the other components as well in some cases.

### <(A) Maleimide-Based Resin>

(A) A maleimide-based resin is one or more selected from the group consisting of a maleimide resin having one or more N-substituted maleimide groups and a derivative of the maleimide resin.

(A) The maleimide-based resin may be used alone or may be used in combination of two or more kinds thereof.

In the following description, the maleimide resin having one or more N-substituted maleimide groups may be referred to as a " maleimide resin (AX)" or a "component (AX)".

In addition, a derivative of the maleimide resin having one or more N-substituted maleimide groups may be referred to as a " maleimide resin derivative (AY)" or a "component (AY)".

### (Maleimide Resin (AX))

The maleimide resin (AX) is not particularly limited as long as it is a maleimide resin having one or more N-substituted maleimide groups.

The maleimide resin (AX) is preferably an aromatic maleimide resin having two or more N-substituted maleimide groups, and more preferably an aromatic bismaleimide resin having two N-substituted maleimide groups, from the viewpoint of adhesion to conductors and heat resistance.

**In** the present description, the "aromatic maleimide resin" means a compound having an N-substituted maleimide group directly bonded to an aromatic ring. Further, in the present description, the "aromatic bismaleimide resin" means a compound having two N-substituted maleimide groups directly bonded to an aromatic ring. Furthermore, in the present description, the "aromatic polymaleimide resin" means a compound having three or more N-substituted maleimide groups directly bonded to an aromatic ring. **In** addition, in the present description, the "aliphatic maleimide resin" means a compound having an N-substituted maleimide group directly bonded to an aliphatic hydrocarbon.

As the maleimide resin (AX), a maleimide resin represented by the following general formula (A-1) is preferable. 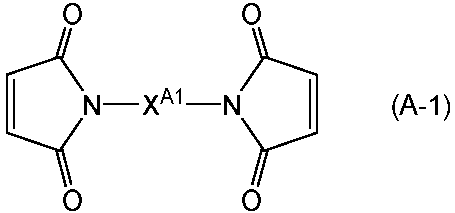 (In the formula, X^{A1} is a divalent organic group.)

X^{A1} in the general formula (A-1) is a divalent organic group.

Examples of the divalent organic group represented by X^{A1} in the general formula (A-1) include a divalent organic group represented by the following general formula (A-2), a divalent organic group represented by the following general formula (A-3), a divalent organic group represented by the following general formula (A-4), a divalent organic group represented by the following general formula (A-5), a divalent organic group represented by the following general formula (A-6), and a divalent organic group represented by the following general formula (A-7). 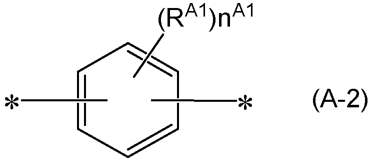 (In the formula, R^{A1} is an aliphatic hydrocarbon group having 1 to 5 carbon atoms or a halogen atom; n^{A1} is an integer of 0 to 4; and * represents a bonding site.)

Examples of the aliphatic hydrocarbon group having 1 to 5 carbon atoms represented by R^{A1} in the general formula (A-2) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group is still more preferable.

Examples of the halogen atom include a fluorine atom, a chlorine atom, a bromine atom, and an iodine atom.

In the general formula (A-2), n^{A1} is an integer of 0 to 4, and from the viewpoint of easy availability, preferably an integer of 0 to 2, more preferably 0 or 1, and still more preferably 0.

When n^{A1} is an integer of 2 or more, a plurality of R^{A1}'s may be the same as or different from each other. 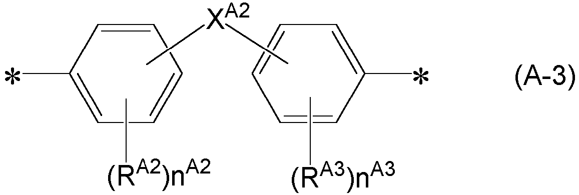 (In the formula, R^{A2} and R^{A3} are each independently an aliphatic hydrocarbon group having 1 to 5 carbon atoms or a halogen atom; X^{A2} is an alkylene group having 1 to 5 carbon atoms, an alkylidene group having 2 to 5 carbon atoms, an ether group, a sulfide group, a sulfonyl group, a carbonyloxy group, a keto group, a single bond, or a divalent organic group represented by the following general formula (A-3-1); n^{A2} and n^{A3} are each independently an integer of 0 to 4; and * represents a bonding site.)

Examples of the aliphatic hydrocarbon group having 1 to 5 carbon atoms represented by R^{A2} and R^{A3} in the general formula (A-3) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group and an ethyl group are still more preferable.

Examples of the halogen atom include a fluorine atom, a chlorine atom, a bromine atom, and an iodine atom.

Examples of the alkylene group having 1 to 5 carbon atoms represented by X^{A2} in the general formula (A-3) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and still more preferably a methylene group.

Examples of the alkylidene group having 2 to 5 carbon atoms represented by X^{A2} in the general formula (A-3) include an ethylidene group, a propylidene group, an isopropylidene group, a butylidene group, an isobutylidene group, a pentylidene group, and an isopentylidene group. Among these, an alkylidene group having 2 to 4 carbon atoms is preferable, an alkylidene group having 2 or 3 carbon atoms is more preferable, and an isopropylidene group is still more preferable.

n^{A2} and n^{A3} in the general formula (A-3) are each independently an integer of 0 to 4.

When n^{A2} or n^{A3} is an integer of 2 or more, a plurality of R^{A2}'s or a plurality of R^{A3}'s may be the same as or different from each other.

The divalent organic group represented by the general formula (A-3-1) represented by X^{A2} in the general formula (A-3) is as follows. 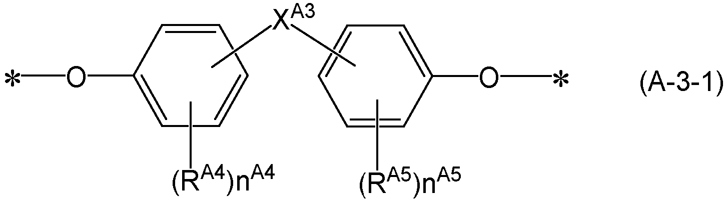 (In the formula, R^{A4} and R^{A5} are each independently an aliphatic hydrocarbon group having 1 to 5 carbon atoms or a halogen atom; X^{A3} is an alkylene group having 1 to 5 carbon atoms, an alkylidene group having 2 to 5 carbon atoms, an ether group, a sulfide group, a sulfonyl group, a carbonyloxy group, a keto group, or a single bond; n^{A4} and n^{A5} are each independently an integer of 0 to 4; and * represents a bonding site.)

Examples of the aliphatic hydrocarbon group having 1 to 5 carbon atoms represented by R^{A4} and R^{A5} in the general formula (A-3-1) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group is still more preferable.

Examples of the halogen atom include a fluorine atom, a chlorine atom, a bromine atom, and an iodine atom.

Examples of the alkylene group having 1 to 5 carbon atoms represented by X^{A3} in the general formula (A-3-1) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and still more preferably a methylene group.

Examples of the alkylidene group having 2 to 5 carbon atoms represented by X^{A3} in the general formula (A-3-1) include an ethylidene group, a propylidene group, an isopropylidene group, a butylidene group, an isobutylidene group, a pentylidene group, and an isopentylidene group. Among these, an alkylidene group having 2 to 4 carbon atoms is preferable, an alkylidene group having 2 or 3 carbon atoms is more preferable, and an isopropylidene group is still more preferable.

n^{A4} and n^{A5} in the general formula (A-3-1) are each independently an integer of 0 to 4, and from the viewpoint of easy availability, both of them are preferably an integer of 0 to 2, more preferably 0 or 1, and still more preferably 0.

When n^{A4} or n^{A5} is an integer of 2 or more, a plurality of R^{A4}'s or a plurality of R^{A5}'s may be the same as or different from each other.

As X^{A2} in the general formula (A-3), among the above-described options, an alkylene group having 1 to 5 carbon atoms, an alkylidene group having 2 to 5 carbon atoms, and a divalent organic group represented by the general formula (A-3-1) are preferable, an alkylene group having 1 to 5 carbon atoms is more preferable, and a methylene group is still more preferable. 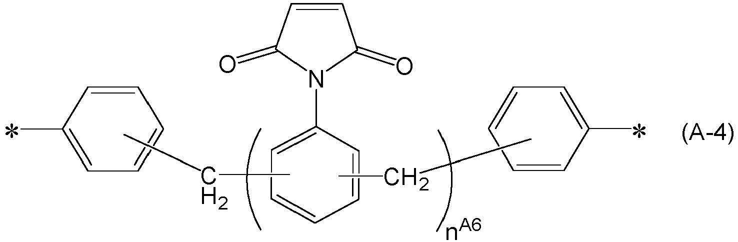 (In the formula, n^{A6} is an integer of 0 to 10; and * represents a bonding site.)

In the general formula (A-4), n^{A6} is preferably an integer of 0 to 5, more preferably an integer of 0 to 4, and still more preferably an integer of 0 to 3, from the viewpoint of easy availability. 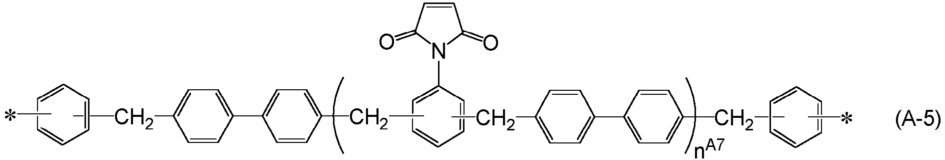 (In the formula, n^{A7} is a number of 0 to 5; and * represents a bonding site.) 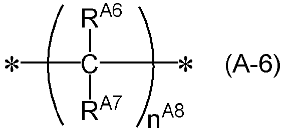 (In the formula, R^{A6} and R^{A7} are each independently a hydrogen atom or an aliphatic hydrocarbon group having 1 to 5 carbon atoms; n^{A8} is an integer of 1 to 8; and * represents a bonding site.)

Examples of the aliphatic hydrocarbon group having 1 to 5 carbon atoms represented by R^{A6} and R^{A7} in the general formula (A-6) include alkyl groups having 1 to 5 carbon atoms such as a methyl group, an ethyl group, a n-propyl group, an isopropyl group, a n-butyl group, an isobutyl group, a t-butyl group, and a n-pentyl group; alkenyl groups having 2 to 5 carbon atoms; and alkynyl groups having 2 to 5 carbon atoms. The aliphatic hydrocarbon group having 1 to 5 carbon atoms may be either linear or branched.

In the general formula (A-6), n^{A8} is an integer of 1 to 8, preferably an integer of 1 to 5, more preferably an integer of 1 to 3, and still more preferably 1. When n^{A8} is an integer of 2 or more, a plurality of R^{A6}'s or a plurality of R^{A7}'s may be the same as or different from each other. 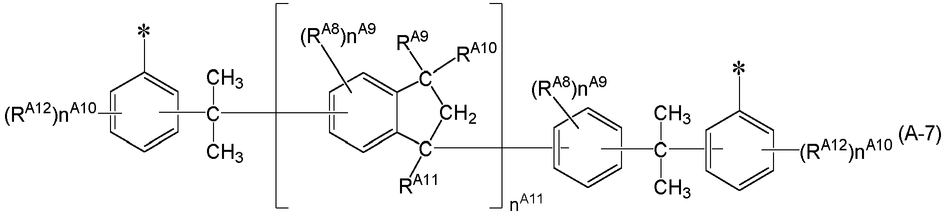 (In the formula, R^{A8} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, and n^{A9} is an integer of 0 to 3; R^{A9} to R^{A11} are each independently an alkyl group having 1 to 10 carbon atoms; R^{A12} is each independently an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group; n^{A10} is each independently an integer of 0 to 4, and n^{A11} is a numerical value of 0.95 to 10.0; and * represents a bonding site.)

Examples of the alkyl group having 1 to 10 carbon atoms represented by R^{A8} in the general formula (A-7) include a methyl group, an ethyl group, a propyl group, a butyl group, a pentyl group, a hexyl group, a heptyl group, an octyl group, and a decyl group. These alkyl groups may be either linear or branched.

Examples of the alkyl groups contained in the alkyloxy group having 1 to 10 carbon atoms and the alkylthio group having 1 to 10 carbon atoms represented by R^{A8} include the same alkyl groups having 1 to 10 carbon atoms as those described above.

Examples of the aryl group having 6 to 10 carbon atoms represented by R^{A8} include a phenyl group and a naphthyl group.

Examples of the aryl groups contained in the aryloxy group having 6 to 10 carbon atoms and the arylthio group having 6 to 10 carbon atoms represented by R^{A8} include the same aryl groups having 6 to 10 carbon atoms as those described above.

Examples of the cycloalkyl group having 3 to 10 carbon atoms represented by R^{A8} include a cyclopropyl group, a cyclobutyl group, a cyclopentyl group, a cyclohexyl group, a cycloheptyl group, a cyclooctyl group, and a cyclodecyl group.

In a case where n^{A9} in the general formula (A-7) is an integer of 1 to 3, from the viewpoint of solvent solubility and reactivity, R^{A8} is preferably an alkyl group having 1 to 4 carbon atoms, a cycloalkyl group having 3 to 6 carbon atoms, or an aryl group having 6 to 10 carbon atoms, and more preferably an alkyl group having 1 to 4 carbon atoms.

Examples of the alkyl group having 1 to 10 carbon atoms represented by R^{A9} to R^{A11} include a methyl group, an ethyl group, a propyl group, a butyl group, a pentyl group, a hexyl group, a heptyl group, an octyl group, and a decyl group. These alkyl groups may be either linear or branched. Among these, R^{A9} to R^{A11} are preferably an alkyl group having 1 to 4 carbon atoms, more preferably a methyl group or an ethyl group, and still more preferably a methyl group.

In the general formula (A-7), n^{A9} is an integer of 0 to 3, and when n^{A9} is 2 or 3, a plurality of R^{A8}'s may be the same as or different from each other.

Among these, the divalent organic group represented by the general formula (A-7) is preferably a divalent organic group in which n^{A9} is 0 and R^{A9} to R^{A11} are each a methyl group, from the viewpoint of compatibility with other resins, solvent solubility, dielectric characteristics, adhesiveness with a conductor, and ease of production.

In the general formula (A-7), a plurality of R^{A8}'s, a plurality of R^{A12}'s, a plurality of n^{A9}'s, and a plurality of n^{A10}'s may be the same as or different from each other, respectively. In addition, in a case where n^{A11} is greater than 1, a plurality of R^{A9}'s, a plurality of R^{A10}'s, and a plurality of R^{A11}'s may be the same as or different from each other, respectively.

The description of the alkyl group having 1 to 10 carbon atoms, the alkyloxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{A12} in the general formula (A-7) is the same as the description of the alkyl group having 1 to 10 carbon atoms, the alkyloxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{A8}.

Among these, from the viewpoint of compatibility with other resins, solvent solubility, dielectric characteristics, adhesiveness with a conductor, and ease of production, R^{A12} is preferably an alkyl group having 1 to 4 carbon atoms, a cycloalkyl group having 3 to 6 carbon atoms, and an aryl group having 6 to 10 carbon atoms, and more preferably an alkyl group having 1 to 3 carbon atoms.

In the general formula (A-7), n^{A10} is an integer of 0 to 4, and from the viewpoint of compatibility with other resins, solvent solubility, dielectric characteristics, adhesiveness with a conductor, and ease of production, n^{A10} is preferably an integer of 0 to 3, and more preferably 0 or 2.

When n^{A10} is one or more, the benzene ring and the N-substituted maleimide group have a twisted conformation, and the intermolecular stacking is suppressed, and thus the solvent solubility tends to be further improved. From the same viewpoint, when n^{A10} is one or more, the substitution position of R^{A12} is preferably an ortho-position with respect to the N-substituted maleimide group.

From the viewpoint of compatibility with other resins, solvent solubility, melt viscosity, handleability, and heat resistance, n^{A11} in the general formula (A-7) is preferably 0.98 to 8.0, more preferably 1.0 to 7.0, and still more preferably 1.1 to 6.0.

Preferred examples of the divalent organic group represented by the general formula (A-7) include a divalent organic group represented by the following general formula (A-7-1), a divalent organic group represented by the following general formula (A-7-2), a divalent organic group represented by the following general formula (A-7-3), and a divalent organic group represented by the following general formula (A-7-4). 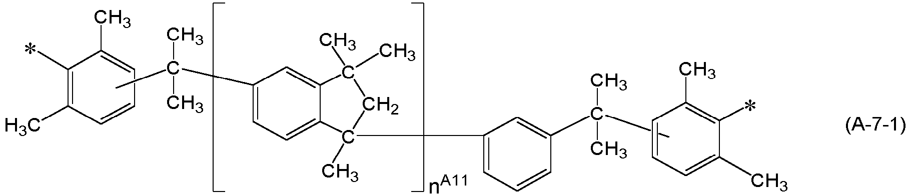 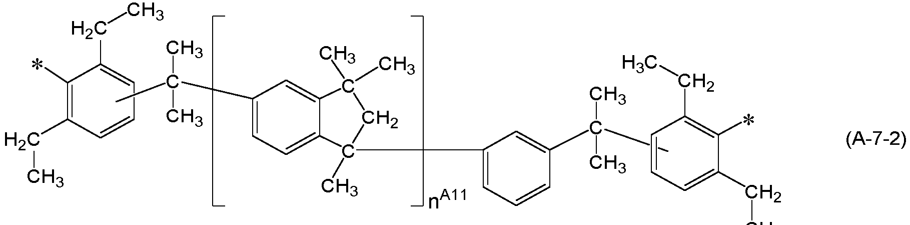 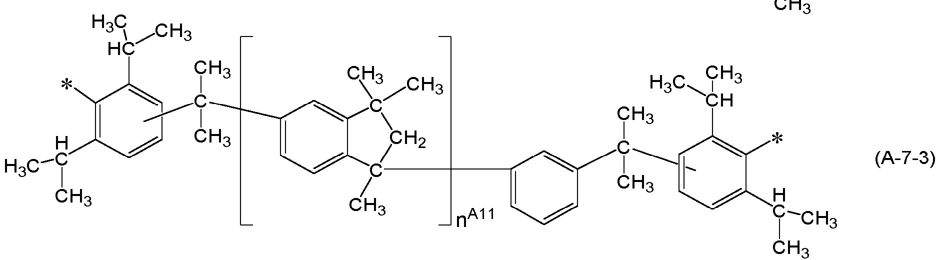 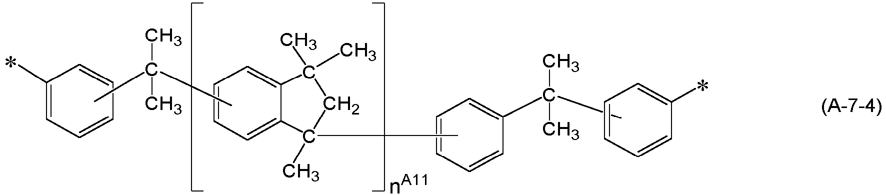 (In the formulae, n^{A11} is the same as defined above in the general formula (A-7); and * represents a bonding site.)

Among the maleimide resins represented by the general formula (A-1), a maleimide resin having a divalent organic group represented by the general formula (A-3) is preferable as X^{A1}, and a maleimide resin having a divalent organic group represented by the general formula (A-7) is preferable as X^{A1}.

Examples of the maleimide resin (AX) include aromatic bismaleimide resins, aromatic polymaleimide resins, and aliphatic maleimide resins, and among these, aromatic bismaleimide resins are preferred.

Specific examples of the maleimide resin (AX) include N,N'-ethylenebismaleimide, N,N'-hexamethylenebismaleimide, N,N'-(1,3-phenylene)bismaleimide, N,N'-[1,3-(2-methylphenylene)]bismaleimide, N,N'-[1,3-(4-methylphenylene)]bismaleimide, N,N'-(1,4-phenylene)bismaleimide, bis(4-maleimidophenyl)methane, bis(3-methyl-4-maleimidophenyl)methane, 3,3'-dimethyl-5,5'-diethyl-4,4'-diphenylmethanebismaleimide, bis(4-maleimidophenyl)ether, bis(4-maleimidophenyl)sulfone, bis(4-maleimidophenyl)sulfide, bis(4-maleimidophenyl)ketone, bis(4-maleimidocyclohexyl)methane, 1,4-bis(4-maleimidophenyl)cyclohexane, 1,4-bis(maleimidomethyl)cyclohexane, 1,4-bis(maleimidomethyl)benzene, 1,3-bis(4-maleimidophenoxy)benzene, 1,3-bis(3-maleimidophenoxy)benzene, bis[4-(3-maleimidophenoxy)phenyl]methane, bis[4-(4-maleimidophenoxy)phenyl]methane, 1,1-bis[4-(3-maleimidophenoxy)phenyl]ethane, 1,1-bis[4-(4-maleimidophenoxy)phenyl]ethane, 1,2-bis[4-(3-maleimidophenoxy)phenyl]ethane, 1,2-bis[4-(4-maleimidophenoxy)phenyl]ethane, 2,2-bis[4-(3-maleimidophenoxy)phenyl]propane, 2,2-bis[4-(4-maleimidophenoxy)phenyl]propane, 2,2-bis[4-(3-maleimidophenoxy)phenyl]butane, 2,2-bis[4-(4-maleimidophenoxy)phenyl]butane, 2,2-bis[4-(3-maleimidophenoxy)phenyl]-1,1,1,3,3,3-hexafluoropropane, 2,2-bis[4-(4-maleimidophenoxy)phenyl]-1,1,1,3,3,3-hexafluoropropane, 4,4-bis(3-maleimidophenoxy)biphenyl, 4,4-bis(4-maleimidophenoxy)biphenyl, bis[4-(3-maleimidophenoxy)phenyl]ketone, bis[4-(4-maleimidophenoxy)phenyl]ketone, bis(4-maleimidophenyl)disulfide, bis[4-(3-maleimidophenoxy)phenyl]sulfide, bis[4-(4-maleimidophenoxy)phenyl]sulfide, bis[4-(3-maleimidophenoxy)phenyl]sulfoxide, bis[4-(4-maleimidophenoxy)phenyl]sulfoxide, bis[4-(3-maleimidophenoxy)phenyl]sulfone, bis[4-(4-maleimidophenoxy)phenyl]sulfone, bis[4-(3-maleimidophenoxy)phenyl]ether, bis[4-(4-maleimidophenoxy)phenyl]ether, 1,4-bis[4-(4-maleimidophenoxy)-α,α-dimethylbenzyl]benzene, 1,3-bis[4-(4-maleimidophenoxy)-α,α-dimethylbenzyl]benzene, 1,4-bis[4-(3-maleimidophenoxy)-α,α-dimethylbenzyl]benzene, 1,3-bis[4-(3-maleimidophenoxy)-α,α-dimethylbenzyl]benzene, 1,4-bis[4-(4-maleimidophenoxy)-3,5-dimethyl-α,α-dimethylbenzyl]benzene, 1,3-bis[4-(4-maleimidophenoxy)-3,5-dimethyl-α,α-dimethylbenzyl]benzene, 1,4-bis[4-(3-maleimidophenoxy)-3,5-dimethyl-α,α-dimethylbenzyl]benzene, 1,3-bis[4-(3-maleimidophenoxy)-3,5-dimethyl-α,α-dimethylbenzyl]benzene, polyphenylmethane maleimide, an aromatic bismaleimide resin having an indane skeleton, and a biphenyl aralkyl type maleimide resin. Among these, bis(4-maleimidophenyl)methane and an aromatic bismaleimide resin having an indane skeleton are preferable.

### (Maleimide Resin Derivative (AY))

As the maleimide resin derivative (AY), an aminomaleimide resin containing a structural unit derived from the above-described maleimide resin (AX) and a structural unit derived from a diamine compound is preferable.

Examples of the structural unit derived from the maleimide resin (AX) contained in the aminomaleimide resin include a structural unit in which at least one N-substituted maleimide group in the N-substituted maleimide group of the maleimide resin (AX) is subjected to a Michael addition reaction with an amino group of the diamine compound.

The structural unit derived from the maleimide resin (AX) contained in the aminomaleimide resin may be one type alone or may be two or more types thereof.

Examples of the structural unit derived from a diamine compound contained in the aminomaleimide resin include a structural unit in which one or both of the amino groups among two amino groups of a diamine compound are subjected to a Michael addition reaction with an N-substituted maleimide group of the maleimide resin (AX).

The structural unit derived from a diamine compound contained in the aminomaleimide resin may be one type alone or may be two or more types thereof.

Examples of the diamine compound include aromatic diamine compounds such as 4,4'-diaminodiphenylmethane, 3,3'-dimethyl-4,4'-diaminodiphenylmethane, 3,3'-diethyl-4,4'-diaminodiphenylmethane, 4,4'-diaminodiphenylether, 4,4'-diaminodiphenylsulfone, 3,3'-diaminodiphenylsulfone, 4,4'-diaminodiphenylketone, 4,4'-diaminobiphenyl, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3'-dimethyl-5,5'-diethyl-4,4'-diaminodiphenylmethane, 2,2-bis(4-aminophenyl)propane, 2,2-bis[4-(4-aminophenoxy)phenyl]propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 1,3-bis[1-[4-(4-aminophenoxy)phenyl]-1-methylethyl]benzene, 1,4-bis[1-[4-(4-aminophenoxy)phenyl]-1-methylethyl]benzene, 4,4'-[1,3-phenylenebis(1-methylethylidene)]bisaniline, 4,4'-[1,4-phenylenebis(1-methylethylidene)]bisaniline, 3,3'-[1,3-phenylenebis(1-methylethylidene)]bisaniline, bis[4-(4-aminophenoxy)phenyl]sulfone, bis[4-(3-aminophenoxy)phenyl]sulfone, and 9,9-bis(4-aminophenyl)fluorene; and silicone compounds having two primary amino groups.

In the present description, the "aromatic diamine compound" means a compound having two amino groups directly bonded to an aromatic ring.

### (Content of (A) Maleimide-Based Resin)

The content of the maleimide-based resin (A) in the resin composition of the present embodiment is not particularly limited, and is preferably 10 to 90 mass%, more preferably 15 to 85 mass%, and still more preferably 20 to 80 mass% with respect to the total amount (100 mass%) of the resin components in the resin composition of the present embodiment.

When the content of the maleimide-based resin (A) is the lower limit value or more, the heat resistance, moldability, processability, and adhesion to conductors tends to be more easily improved. On the other hand, when the content of the maleimide-based resin (A) is the upper limit value or less, the dielectric characteristics tend to be more easily improved.

Here, in the present description, the "resin component" means a resin and a compound which forms a resin by a curing reaction.

For example, in the resin composition of the present embodiment, the component (A) and the component (B) correspond to resin components.

In a case where the resin composition of the present embodiment contains, as an optional component, a resin or a compound that forms a resin by a curing reaction in addition to the above-described components, these optional components are also included in the resin component.

### <(B) Compound having Vinyl Benzyl Group>

(B) The compound having a vinyl benzyl group (hereinafter, also referred to as "vinyl benzyl compound (B)") contains one or more selected from the group consisting of (B1) a compound having three or more vinyl benzyl groups bonded to an oxygen atom and (B2) a compound having one or more vinyl benzyl groups bonded to a carbon atom.

The vinyl group which is a reactive group contained in the vinyl benzyl compound (B) has a lower polarity than the N-substituted maleimide group contained in the component (A). Therefore, the resin composition of the present embodiment containing the vinyl benzyl compound (B) can develop excellent dielectric characteristics.

The component (B) may be used alone or may be used in combination of two or more kinds thereof.

The vinyl benzyl group contained in the component (B) may be any of an o-vinylbenzyl group, an m-vinylbenzyl group or a p-vinylbenzyl group, and is preferably a p-vinylbenzyl group from the viewpoint of the dielectric characteristics.

The content of the p-vinyl benzyl group in all vinyl benzyl groups contained in the component (B) is not particularly limited, and is preferably 10 to 100 mass%, more preferably 15 to 95 mass%, still more preferably 20 to 90 mass%, and particularly preferably 25 to 85 mass% from the viewpoint of a low dielectric dissipation factor.

### ((B1) Compound Having Three or More Vinyl Benzyl Groups Bonded to Oxygen Atom)

The component (B1) is not particularly limited as long as it is a compound having three or more vinyl benzyl groups directly bonded to an oxygen atom.

The resin composition of the present embodiment contains the component (B1) as the component (B), whereby excellent dielectric characteristics can be obtained, and it is possible to improve the curability.

The number of the vinyl benzyl groups bonded to an oxygen atom in one molecule of the component (B1) is 3 or more, preferably 50 or less, and more preferably 30 or less from the viewpoint of solvent solubility.

The weight-average molecular weight (Mw) of the component (B1) is not particularly limited, and is preferably 300 to 50,000, more preferably 500 to 30,000, and still more preferably 1,000 to 10,000 from the viewpoint of moldability and handleability.

The component (B) contains the component (B1), and the component (B1) is preferably a compound having a structural unit represented by the following general formula (B1-1) from the viewpoint of curability, moldability, and handleability.

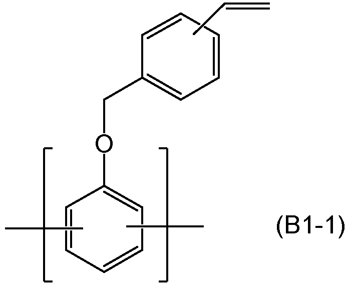

The vinyl benzyl groups bonded to an oxygen atom of the component (B1) are all preferably included in the structural unit represented by the general formula (B1-1).

The component (B1) containing the structural unit represented by the general formula (B1-1) is preferably a compound represented by the following general formula (B1-2). 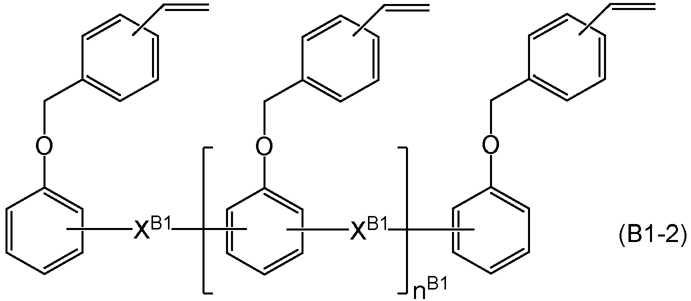 (In the formula, X^{B1}'s are each independently a divalent hydrocarbon group, and n^{B1} is an integer of 1 to 5.)

Examples of the divalent hydrocarbon group represented by X^{B1} in the general formula (B1-2) include an alkylene group having 1 to 5 carbon atoms, an alkylidene group having 2 to 5 carbon atoms, a divalent alicyclic hydrocarbon group having 5 to 12 carbon atoms, an arylene group having 6 to 12 carbon atoms, and a divalent group formed by combining these groups.

Examples of the alkylene group having 1 to 5 carbon atoms include a methylene group, a 1,2-dimethylene group, a 1,3-trimethylene group, a 1,4-tetramethylene group, and a 1,5-pentamethylene group.

Examples of the alkylidene group having 2 to 5 carbon atoms include an ethylidene group, a propylidene group, an isopropylidene group, a butylidene group, an isobutylidene group, a pentylidene group, and an isopentylidene group.

Examples of the divalent alicyclic hydrocarbon group having 5 to 12 carbon atoms include divalent group formed by losing two hydrogen atoms bonded to two different carbon atoms from an alicyclic hydrocarbon compound such as norbornane, decalin, bicycloundecane, or saturated dicyclopentadiene.

Examples of the arylene group having 6 to 12 carbon atoms include a phenylene group, a naphthylene group, and a biphenylene group.

X^{B1} is preferably a group obtained by combining an alkylene group having 1 to 5 carbon atoms and an arylene group having 6 to 12 carbon atoms, and more preferably a divalent group represented by the following general formula (B1-2-1).

*-X^{B2}-Ar^{B1}-X^{B2}-* (B1-2-1)

(In the formula, X^{B2}'s are each independently an alkylene group having 1 to 5 carbon atoms, Ar^{B1} is an arylene group having 6 to 12 carbon atoms; and * represents a bonding site.)

The alkylene group having 1 to 5 carbon atoms represented by X^{B2} is preferably a methylene group among those listed above.

The arylene group having 6 to 12 carbon atoms represented by Ar^{B1} is preferably a phenylene group or a biphenylene group among those listed above. In addition, the phenylene group is preferably a 1,4-phenylene group, and the biphenylene group is preferably a 4,4' - biphenylene group.

n^{B1} in the general formula (B1-2) is an integer of 1 to 50, preferably an integer of 1 to 30, and more preferably an integer of 1 to 20.

### ((B2) Compound Having One or More Vinyl Benzyl Groups Bonded to Carbon Atom)

The component (B2) is not particularly limited as long as it is a compound having one or more vinyl benzyl groups directly bonded to a carbon atom.

The resin composition of the present embodiment contains the component (B2) as the component (B), whereby particularly excellent dielectric characteristics can be obtained.

The number of the vinyl benzyl groups bonded to a carbon atom in one molecule of the component (B2) may be 1 or more, preferably 2 to 4, and more preferably 2 or 3.

The weight-average molecular weight (Mw) of the component (B2) is not particularly limited, and is preferably 200 to 800, more preferably 250 to 750, and still more preferably 300 to 700 from the viewpoint of moldability and handleability.

The component (B) preferably contains the component (B2), and the component (B2) is preferably a compound having a condensed polycyclic structure containing an aromatic ring and a non-aromatic ring.

Examples of the condensed polycyclic structure containing an aromatic ring and a non-aromatic ring in the component (B2) include a fluorene ring, an indene ring, an indane ring, a phenanthrene ring, and an acenaphthylene ring. Among these, from the viewpoint of dielectric characteristics, a fluorene ring and an indene ring are preferable.

The component (B2) having a fluorene ring is preferably a compound represented by the following general formula (B2-1) from the viewpoint of dielectric characteristics. 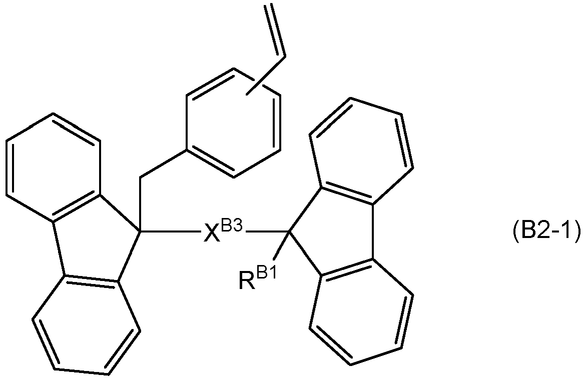 (In the formula, X^{B3} is an alkylene group having 1 to 10 carbon atoms, and R^{B1} is a hydrogen atom or a vinyl benzyl group.)

Examples of the alkylene group having 1 to 10 carbon atoms represented by X^{B3} in the general formula (B2-1) include a methylene group, a 1,2-dimethylene group, a 1,3-trimethylene group, a 1,4-tetramethylene group, a 1,5-pentamethylene group, and a 1,6-hexamethylene group.

The component (B2) having an indene ring is preferably a compound represented by the following general formula (B2-2) from the viewpoint of dielectric characteristics. 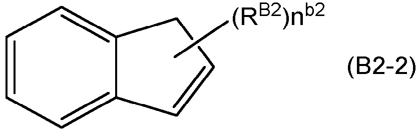 (In the formula, R^{B2}'s are each independently a vinyl benzyl group, and n^{b2} is an integer of 1 to 3.)

The compound represented by the general formula (B2-2) may be any of a compound having one vinyl benzyl group, a compound having two vinyl benzyl groups, and a compound having three vinyl benzyl groups or may be a mixture thereof. In the case of a mixture, the average number of the vinyl benzyl groups in one molecule of the compound represented by the general formula (B2-2) is preferably from 1.4 to 2.8, more preferably from 1.6 to 2.7, and still more preferably from 1.8 to 2.6.

As the component (B), a commercially available product may be used, or a component synthesized by a known method may be used.

Examples of a method for synthesizing the component (B) include a method in which a base compound for introducing a vinyl benzyl group and styrene having a halogenated methyl group are reacted in the presence of a basic compound. Examples of the base compound include a compound having a phenolic hydroxy group; and a compound having a condensed polycyclic structure containing an aromatic ring such as fluorene, indene, indane, phenanthrene, or acenaphthylene, and a non-aromatic ring.

Examples of the styrene having a halogenated methyl group include o-chloromethylstyrene, m-chloromethylstyrene, p-chloromethylstyrene, and mixtures thereof.

Examples of the basic compound include alkali metal hydroxides and alkali metal alkoxides.

During the above reaction, a phase transfer catalyst may be used. Examples of the phase transfer catalyst include tetrabutylammonium bromide.

The reaction is preferably performed under heating and stirring, and the obtained product may be purified as necessary by a known method such as condensation, reprecipitation, or washing.

The total content of one or more selected from the group consisting of the component (B1) and the component (B2) in the component (B) is not particularly limited, and is preferably 80 to 100 mass%, more preferably 90 to 100 mass%, and still more preferably 95 to 100 mass% based on the total amount of the component (B) from the viewpoint of dielectric characteristics.

### (Content of Vinyl benzyl Compound (B))

The content of the vinyl benzyl compound (B) in the resin composition of the present embodiment is not particularly limited, and is preferably 10 to 90 mass%, more preferably 15 to 85 mass%, and still more preferably 20 to 80 mass% with respect to the total amount (100 mass%) of the resin components in the resin composition of the present embodiment.

When the content of the vinyl benzyl compound (B) is the lower limit value or more, the dielectric characteristics tend to be more easily improved. In addition, when the content of the vinyl benzyl compound (B) is the upper limit value or less, the conductor adhesiveness tends to be more easily improved.

The content ratio [N-substituted maleimide group/vinyl group] of the N-substituted maleimide group derived from the component (A) to a vinyl group derived from the component (B) in the resin composition of the present embodiment is not particularly limited, and is preferably from 0.05 to 5, more preferably from 0.10 to 3, and still more preferably from 0.15 to 1.2 on a molar basis from the viewpoints of dielectric characteristics, curability, moldability, and adhesion to conductors. In addition, the content ratio [N-substituted maleimide group/vinyl group] may be 1.0 or less, 0.6 or less, 0.4 or less, or 0.3 or less on a molar basis from the viewpoint of dielectric characteristics.

### <Other Components>

The resin composition of the present embodiment may or may not contain other components other than each of the above-described components as necessary.

Examples of the other components include an elastomer, an inorganic filler, a curing accelerator, an organic solvent, and other additives.

Each of these other components may be used alone, or two or more kinds may be used in combination.

### (Elastomer)

Examples of the elastomer include styrene elastomers, olefin elastomers, urethane elastomers, polyester elastomers, polyamide elastomers, acrylic elastomers, silicone elastomers, and derivatives thereof.

### (Inorganic Filler)

Examples of the inorganic filler include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide.

### (Curing Accelerator)

Examples of the curing accelerator include acidic catalysts such as p-toluenesulfonic acid; amine compounds such as triethylamine, pyridine, and tributylamine; imidazole compounds such as methylimidazole and phenylimidazole; isocyanate-masked imidazole compounds such as an addition reaction product of hexamethylene diisocyanate resin and 2-ethyl-4-methylimidazole; tertiary amine compounds; quaternary ammonium compounds; phosphorus-based compounds such as triphenylphosphine; organic peroxides such as dicumyl peroxide, 2,5-dimethyl-2,5-bis(t-butylperoxy)hexyne-3,2,5-dimethyl-2,5-bis(t-butylperoxy)hexane, t-butylperoxyisopropyl monocarbonate, and α,α'-bis(t-butylperoxy)diisopropylbenzene; and carboxylates of manganese, cobalt, and zinc.

### (Organic Solvent)

Examples of the organic solvent include alcohol-based solvents such as ethanol, propanol, butanol, methyl cellosolve, butyl cellosolve, and propylene glycol monomethyl ether; ketone-based solvents such as acetone, methyl ethyl ketone, methyl isobutyl ketone, and cyclohexanone; ether-based solvents such as tetrahydrofuran; aromatic hydrocarbon-based solvents such as toluene, xylene, and mesitylene; nitrogen atom-containing solvents such as dimethylformamide, dimethylacetamide, and N-methylpyrrolidone; sulfur atom-containing solvents such as dimethyl sulfoxide; and ester-based solvents such as γ-butyrolactone.

### (Other Additives)

Examples of other additives include a flame retardant, an antioxidant, a thermal stabilizer, an antistatic agent, an ultraviolet absorbent, a pigment, a colorant, and a lubricant.

### <Method for Producing Resin Composition>

The resin composition of the present embodiment can be produced by mixing the component (A), the component (B), other components used in combination as necessary by a known method. In this case, the respective components may be dissolved or dispersed while stirring. Conditions such as a mixing order, a temperature, and a time are not particularly limited, and may be arbitrarily set according to the type or the like of raw material.

### <Relative Permittivity (Dk) of Cured Product>

The relative permittivity (Dk) at 10 GHz of the cured product of the resin composition of the present embodiment is not particularly limited, and is preferably 3.0 or less, more preferably 2.8 or less, and still more preferably 2.7 or less. The relative permittivity (Dk) is preferably as small as possible, and the lower limit value thereof is not particularly limited, and may be, for example, 2.3 or more, or 2.4 or more, in consideration of the balance with other physical properties.

The relative permittivity (Dk) is a value in accordance with a cavity resonator perturbation method, and more specifically, a value measured by a method described in Examples.

### <Dielectric Dissipation Factor (Df) of Cured Product>

The dielectric dissipation factor (Df) at 10 GHz of the cured product of the resin composition of the present embodiment is not particularly limited, and is preferably 0.0080 or less, more preferably 0.0070 or less, and still more preferably 0.0060 or less. The dielectric dissipation factor (Df) is preferably as small as possible, and the lower limit value thereof is not particularly limited, and may be, for example, 0.0010 or more, or 0.0015 or more, in consideration of the balance with other physical properties.

The dielectric dissipation factor (Df) is a value in accordance with a cavity resonator perturbation method, and more specifically, a value measured by a method described in Examples.

### [Prepreg]

The prepreg of the present embodiment is a prepreg containing the resin composition of the present embodiment or a semi-cured product of the resin composition.

The prepreg of the present embodiment contains, for example, the resin composition of the present embodiment or a semi-cured product of the resin composition and a sheet-shaped fiber base material.

As the sheet-shaped fiber base material contained in the prepreg of the present embodiment, for example, known sheet-shaped fiber base materials used in various laminates for electrical insulating materials can be used.

Examples of the material of the sheet-shaped fiber base material include inorganic fibers such as E glass, D glass, S glass, and Q glass; organic fibers such as polyimide, polyester, and tetrafluoroethylene; and mixtures thereof. These sheet-shaped fiber base materials have a shape of, for example, a woven fabric, a nonwoven fabric, a roving, a chopped strand mat, or a surfacing mat.

The prepreg of the present embodiment can be produced by, for example, impregnating or coating the resin composition of the present embodiment into a sheet-shaped fiber base material and then heating and drying the impregnated or coated resin composition to make it B-stage.

The temperature and time of the heating and drying are not particularly limited, and from the viewpoint of productivity and appropriate B-staging of the resin composition of the present embodiment, for example, the temperature and time can be set to 50 to 200°C and 1 to 30 minutes.

The solid content concentration derived from the resin composition in the prepreg of the present embodiment is not particularly limited, and from the viewpoint of easily obtaining better moldability when a laminate is formed, the solid content concentration is preferably 20 to 90 mass%, more preferably 25 to 80 mass%, and still more preferably 30 to 75 mass%.

### [Resin Film]

The resin film of the present embodiment is a resin film containing the resin composition of the present embodiment or a semi-cured product of the resin composition.

The resin film of the present embodiment can be produced, for example, by coating the resin composition of the present embodiment containing an organic solvent, that is, a resin varnish, on a support and then heating and drying the coating.

Examples of the support include a plastic film, a metal foil, and a release paper.

The temperature and time of the heating and drying are not particularly limited, and from the viewpoint of productivity and appropriate B-staging of the resin composition of the present embodiment, the temperature and time can be set to 50 to 200°C and 1 to 30 minutes.

The resin film of the present embodiment is preferably used for forming an insulating layer in the case of producing a printed wiring board.

### [Laminate]

The laminate of the present embodiment is a laminate having a cured product of the resin composition of the present embodiment, and a metal foil.

A laminate having a metal foil is sometimes referred to as a metal-clad laminate.

The metal of the metal foil is not particularly limited, and examples thereof include copper, gold, silver, nickel, platinum, molybdenum, ruthenium, aluminum, tungsten, iron, titanium, chromium, and an alloy containing one or more kinds of these metal elements.

The laminate of the present embodiment can be produced, for example, by disposing a metal foil on one surface or both surfaces of the prepreg of the present embodiment, and then subjecting the prepreg to heating and press molding.

Usually, the B-staged prepreg is cured by this heating and press molding to obtain the laminate of the present embodiment.

When the heating and press molding is performed, only one prepreg may be used, or two or more prepregs may be laminated.

For the heating and press molding, for example, a multi-stage press, a multi-stage vacuum press, a continuous molding, or an autoclave molding machine can be used.

The conditions of the heating and press molding are not particularly limited, and the temperature may be 100 to 300°C, the time may be 10 to 300 minutes, and the pressure may be 1.5 to 5 MPa, for example.

### [Printed Wiring Board]

The printed wiring board of the present embodiment is a printed wiring board having a cured product of the resin composition of the present embodiment.

The printed wiring board of the present embodiment can be produced, for example, by performing conductor circuit formation by a known method on one or more kinds of materials selected from the group consisting of a cured product of the prepreg of the present embodiment, a cured product and a laminate of the resin film of the present embodiment. **In** addition, a multilayer printed wiring board can also be produced by further performing a multilayer adhesion process as necessary. The conductor circuit can be formed by, for example, appropriately performing a drilling process, a metal plating process, or etching of a metal foil.

### [Semiconductor Package]

A semiconductor package of a first aspect of the present embodiment is a semiconductor package having the printed wiring board of the present embodiment and a semiconductor element.

The semiconductor package of the first aspect of the present embodiment can be produced, for example, by mounting a semiconductor element and a memory on the printed wiring board of the present embodiment by a known method.

A semiconductor package of a second aspect of the present embodiment is a semiconductor package including a semiconductor element and a cured product of the resin composition of the present embodiment for sealing the semiconductor element.

The semiconductor package of the second aspect of the present embodiment can be produced by, for example, a method in which at least a part of a semiconductor element mounted on a printed wiring board is covered with the resin composition of the present embodiment and the resin composition is cured.

### Example

Hereinafter, the present embodiment will be specifically described with reference to Examples. However, the present embodiment is not limited to the following Examples.

In each example, the weight-average molecular weight (Mw) and the number-average molecular weight (Mn) were measured by the following procedure.

### (Method for Measuring Weight-Average Molecular Weight (Mw) and Number-Average Molecular Weight (Mn))

The weight-average molecular weight (Mw) and the number-average molecular weight (Mn) were converted from a calibration curve using standard polystyrene by gel permeation chromatography (GPC). The calibration curve was approximated by a cubic equation using standard polystyrene: TSK standard POLYSTYRENE (Type; A-2500, A-5000, F-20, F-80) [manufactured by Tosoh Corporation, trade name]. The measurement conditions of GPC are shown below.
Apparatus: High-speed GPC apparatus HLC-8320GPC
Detector: Ultraviolet absorption detector UV-8320 [manufactured by Tosoh Corporation]
Column: Guard column; TSKgel guard column Super(HZ)-M + Column; TSKgel SuperMultipore HZ-M (two columns); reference column; TSKgel SuperH-RC (two columns) (all manufactured by Tosoh Corporation, trade names)
Column size: 4.6 × 20 mm (guard column), 4.6 × 150 mm (column), 6.0 × 150 mm (reference column)
Eluent: Tetrahydrofuran
Sample concentration: 10 mg/1 mL
Injection volume: 20 µL or 2 µL
Flow rate: 0.35 mL/min
Measurement temperature: 40°C

### [Production of Vinyl benzyl Compounds]

### Production Examples 1 to 3

### (Production of Vinyl benzyl Compounds 1 to 3)

A 500 mL-volume reaction vessel equipped with a stirrer, a thermometer, a reflux tube, and an air pump was charged with a base compound, a chloromethylstyrene, a phase transfer catalyst, pure water, a polymerization inhibitor, and a solvent at amounts shown in Table 1, and heated and stirred at 40°C while blowing an air at a flow rate of 50 ml/min.

Next, while maintaining the temperature at 70°C, an amount, which is shown in Table 1, of a basic compound was added dropwise over 20 minutes, and furthermore, stirred at 70°C for 4 hours. During a reaction, the blowing of an air was continued. A reaction product was cooled to room temperature (25°C) and neutralized with a 10% hydrochloric acid aqueous solution, and an organic layer was then washed with pure water three times. Thereafter, the organic layer was precipitated in methanol to obtain target vinyl benzyl compounds 1 to 3. It was confirmed by infrared absorption (IR) spectrum analysis that the vinyl benzyl compounds 1 to 3 had a structure in which phenolic hydroxy groups contained in the base compound were substantially all substituted with vinyl benzyl ether groups and corresponded to a component (B1).

### Production Examples 4 and 5

### (Production of Vinyl benzyl Compounds 4 and 5)

A 500 mL-volume reaction vessel equipped with a stirrer, a thermometer, a reflux tube, and a nitrogen port was charged with a base compound, a chloromethylstyrene, a phase transfer catalyst, a polymerization inhibitor, and a solvent at amounts shown in Table 1, and heated and stirred at 40°C while blowing nitrogen at a flow rate of 50 ml/min.

Next, an amount, which is shown in Table 1, of a basic compound was added dropwise over 20 minutes, and furthermore, stirred at 60°C for 9 hours. During a reaction, the blowing of nitrogen was continued. A reaction product was cooled to room temperature (25°C), neutralized with a 10% hydrochloric acid aqueous solution, and then washed with pure water twice, toluene was distilled off under reduced pressure, and the obtained viscous liquid was then washed with methanol and then dried in a vacuum, thereby obtaining vinyl benzyl compounds 4 and 5. It was confirmed by ¹H-NMR analysis that the vinyl benzyl compounds 4 and 5 had a structure in which two hydrogen atoms directly bonded to the carbon atom at the first position of indene represented by the following formula (B2-3) were substantially all substituted with vinyl benzyl groups and corresponded to a component (B2). **In** addition, GPC analysis showed that the vinyl benzyl compounds 4 and 5 were mixtures of a compound into which two vinyl benzyl groups had been introduced and a compound into which three vinyl benzyl groups had been introduced.

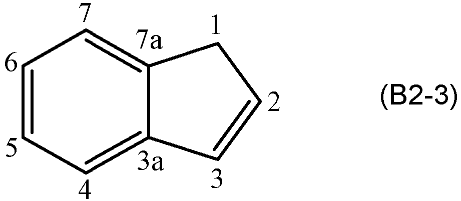

The weight-average molecular weights (Mw) of the vinyl benzyl compounds 1 to 5 are shown in Table 1.

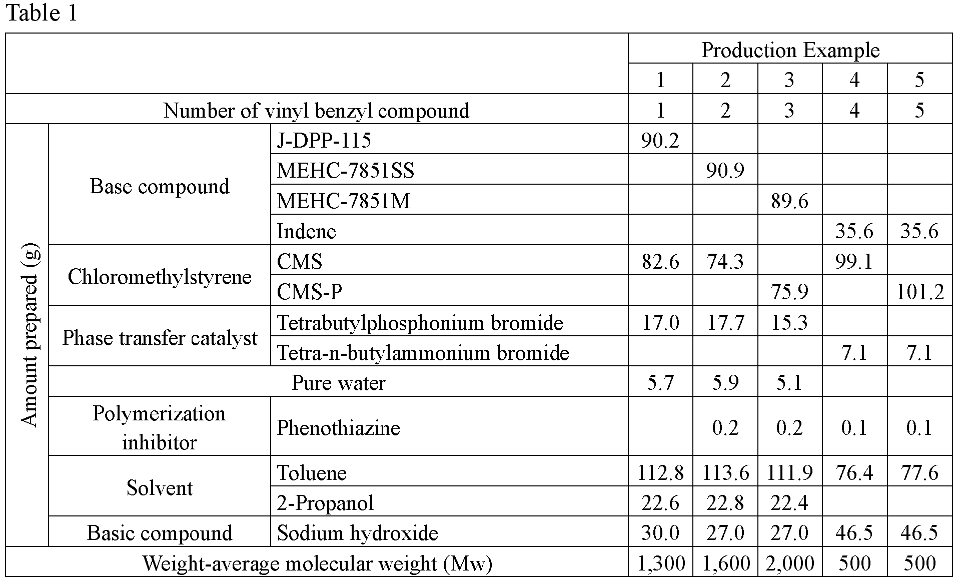

The details of the compounds shown in Table 1 are as follows.

### (Base Compounds)

· J-DPP-115: Phenol resin having a dicyclopentadiene skeleton, manufactured by JFE Chemical Corporation, hydroxy group equivalent amount: 177 to 182 g/eq
· MEHC-7851SS: Biphenyl aralkyl type phenol resin, manufactured by Meiwa Plastic Industries, Ltd., weight-average molecular weight (Mw): 1,000, number-average molecular weight (Mn): 700, hydroxy group equivalent amount 201 to 220 g/eq
· MEHC-7851M: Biphenyl aralkyl type phenol resin, manufactured by Meiwa Plastic Industries, Ltd., weight-average molecular weight (Mw): 1,500, number-average molecular weight (Mn): 900, hydroxy group equivalent amount 201 to 220 g/eq

### (Chloromethylstyrene)

· CMS: Manufactured by Changzhou Wujin Linchuan Chemical Co., Ltd., a mixture of an o-isomer and a p-isomer, o-isomer content: 17 mass%, p-isomer content: 83 mass%
· CMS-P: Manufactured by AGC Seimi Chemical Co., Ltd., a mixture of an m-isomer and a p-isomer, m-isomer content: 50 mass%, p-isomer content: 50 mass%

### (Phase Transfer Catalyst)

· Tetrabutylphosphonium bromide: Manufactured by Kanto Chemical Co., Inc.
· Tetra-n-butylammonium bromide: Manufactured by Kanto Chemical Co., Inc.

### (Basic Compound)

· Sodium hydroxide: Manufactured by Kanto Chemical Co., Inc., an aqueous solution having a concentration of 48 mass%

### [Production of Resin Composition]

### Examples 1 to 6 and Comparative Examples 1 and 2

Each component shown in Table 2 was mixed in a powder state or blended together with toluene and methyl ethyl ketone in accordance with the blending amount shown in Table 2, stirred and mixed at 25°C to prepare resin compositions having a solid content concentration of about 60 mass%. In Table 2, the unit of the blending amount of each component is parts by mass, and in the case of a solution, the unit means parts by mass in terms of solid content.

The resin composition obtained in each example was applied to a PET film (manufactured by Teijin Limited. trade name: G2000) having a thickness of 38 µm, and then heated and dried at 140°C for 5 minutes, thereby preparing a resin film in a B-stage state. This resin film was peeled off from the PET film and then pulverized, thereby obtaining a resin powder. Next, the above-described resin powder was injected into a Teflon (registered trademark) sheet that had been die-cut into size of 1 mm in thickness, 50 mm in length, and 30 mm in width, and 18 µm-thick low profile copper foils (manufactured by Mitsui Mining & Smelting Co., Ltd., trade name: SI-VSP) were disposed above and below the Teflon sheet in a state in which the S surface contacts with the injected resin powder. Subsequently, the resin composition was cured by heating and press molding the laminate in a vacuum under the conditions of a temperature of 150°C, a pressure of 1.5 to 2.0 MPa, and a time of 120 minutes and further heating and molding the laminate under the conditions of a temperature of 180°C and a time of 300 minutes. Thereafter, the copper foils on both sides were peeled off, thereby obtaining a resin plate (resin plate thickness: 1 mm).

### [Evaluation Method and Measurement Method]

Using the resin plates obtained in the examples and the comparative examples, each measurement and evaluation were performed according to the following methods. The results are shown in Table 2.

### (Evaluation of Moldability)

The appearance of the resin plate obtained in each example was visually confirmed and evaluated according to the following criteria.

A: There are no voids on the surface of the resin plate, and cutting is possible.

C: There is a void on the surface of the resin plate, and cutting is impossible.

### (Method for Measuring Relative Permittivity (Dk) and Dielectric Dissipation Factor (Df))

A 1 mm × 50 mm test piece was prepared by cutting the resin plate obtained in each example. Next, the relative permittivity (Dk) and the dielectric dissipation factor (Df) of the test piece were measured in a 10 GHz band at an atmospheric temperature of 25°C in accordance with the cavity resonator perturbation method. The resin composition of Comparative Example 1 had poor moldability and did not make it possible to prepare a test piece for measuring the relative permittivity (Dk) and the dielectric dissipation factor (Df), and the relative permittivity and the dielectric dissipation factor were regarded as "not measurable".

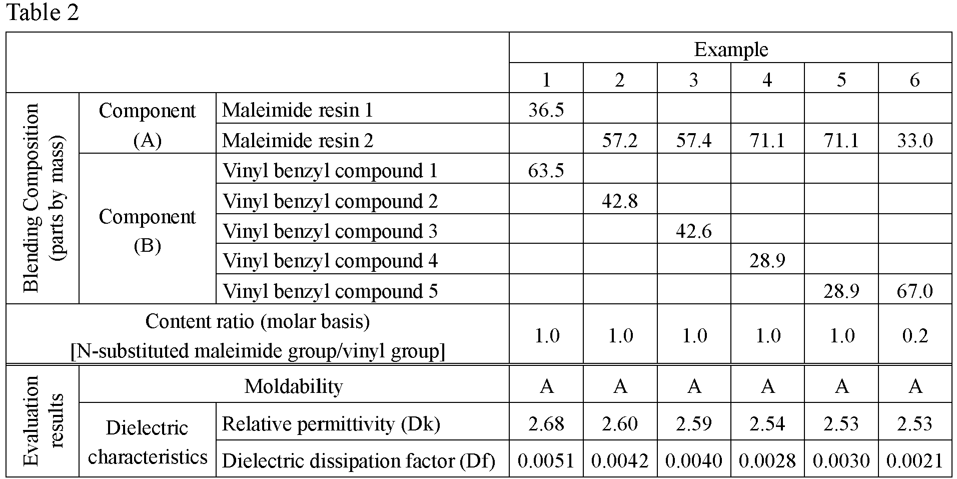

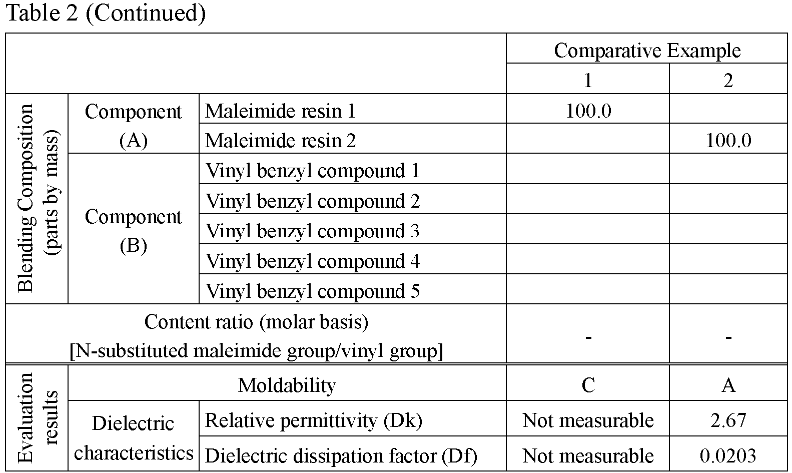

Each material shown in Table 2 is as follows.
[Component (A)]
   · maleimide resin 1: Bis(4-maleimidophenyl)methane
   · maleimide resin 2: Aromatic bismaleimide resin having an indane ring
[Component (B)]
   . Vinyl benzyl compounds 1 to 5: Vinyl benzyl compounds 1 to 5 obtained in Production Examples 1 to 5

From the results shown in Table 2, it can be seen that all of the resin compositions of Examples 1 to 6 of the present embodiment have a low relative permittivity (Dk) and a low dielectric dissipation factor (Df), and have excellent dielectric characteristics while having good moldability.

On the other hand, the resin composition of Comparative Example 1 containing no component (B) had poor moldability. In addition, the resin composition of Comparative Example 2 containing no component (B) had poor dielectric characteristics.

In particular, when Examples 2 to 6 and Comparative Example 2, in which the same component (A) was used, are compared, it can be seen that the dielectric dissipation factor (Df) has significantly reduced in the resin compositions of Examples 2 to 6 than in the resin composition of Comparative Example 2, and the reduction amount thereof is so remarkable that it exceeds a range predicted from the blending amount of the component (B).

### Industrial Applicability

Since the resin composition of the present embodiment has excellent dielectric characteristics, a prepreg, a laminate, a printed wiring board, and a semiconductor package obtained using the resin composition are particularly suitable for electronic components handling high-frequency signals.

## Claims

1. A resin composition comprising:
(A) one or more selected from the group consisting of a maleimide resin having one or more N-substituted maleimide groups and a derivative of the maleimide resin; and
(B) a compound having a vinyl benzyl group,
wherein the component (B) contains one or more selected from the group consisting of (B1) a compound having 3 or more vinyl benzyl groups bonded to an oxygen atom and (B2) a compound having one or more vinyl benzyl groups bonded to a carbon atom.

2. The resin composition according to claim 1, wherein the component (B) contains the component (B1), and
the component (B1) is a compound having a structural unit represented by the following general formula (B-1):

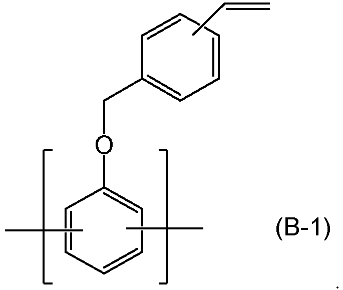

3. The resin composition according to claim 1, wherein the component (B) contains the component (B2), and
the component (B2) is a compound having a condensed polycyclic structure containing an aromatic ring and a non-aromatic ring.

4. The resin composition according to claim 3, wherein the condensed polycyclic structure containing an aromatic ring and a non-aromatic ring is an indene ring.

5. The resin composition according to any one of claims 1 to 4, wherein the component (A) is an aromatic bismaleimide resin having two N-substituted maleimide groups.

6. The resin composition according to any one of claims 1 to 4, wherein a content ratio [N-substituted maleimide group/vinyl group] of the N-substituted maleimide group derived from the component (A) to a vinyl group derived from the component (B) is 0.05 to 5 on a molar basis.

7. A prepreg comprising:
the resin composition according to any one of claims 1 to 4 or a semi-cured product of the resin composition.

8. A laminate comprising:
a cured product of the resin composition according to any one of claims 1 to 4; and
a metal foil.

9. A resin film comprising:
the resin composition according to any one of claims 1 to 4 or a semi-cured product of the resin composition.

10. A printed wiring board comprising:
a cured product of the resin composition according to any one of claims 1 to 4.

11. A semiconductor package comprising:
the printed wiring board according to claim 10; and
a semiconductor element.

12. A semiconductor package comprising:
a semiconductor element; and
a cured product of the resin composition according to any one of claims 1 to 4 that seals the semiconductor element.
